# FASCICULE DE BREVET EUROPEEN

(11) **EP 2 588 815 B1**
(45) Date de publication et mention de la délivrance du brevet: **09.09.2015**
(21) Numéro de dépôt: 11728857.1
(22) Date de dépôt: 01.07.2011
(51) Int. Cl.: F24J 2/52, E04D 3/02, H01L 31/042, E04B 1/26, E04D 13/18

(54) **INSTALLATION D'ABSORPTION D'ENERGIE SOLAIRE**
ANLAGE ZUR GEWINNUNG VON SONNENENERGIE
INSTALLATION FOR COLLECTING SOLAR ENERGY

(30) Priorité: 01.07.2010 FR 1055337
(43) Date de publication de la demande: 08.05.2013
(73) Titulaire: SunPower Corporation, San Jose, CA 95134 (US)
(72) Inventeur: MICALLEF, Yann, F-69005 Lyon (FR); CARRE, Guillaume, F-69005 Lyon (FR)
(74) Mandataire: Grünecker Patent- und Rechtsanwälte PartG mbB
(86) Numéro de dépôt international: PCT/EP2011/061152
(87) Numéro de publication internationale: WO 2012/001162

(56) Documents cités:
- EP-A1- 2 149 648
- AU-A1- 2009 245 849
- DE-A1- 10 017 125
- DE-U1- 9 109 605
- FR-A1- 2 935 410
- JP-A- 57 169 544
- JP-A- 2002 030 773

## Description

La présente invention est relative à une installation de récupération d'énergie solaire.

Plus particulièrement, l'invention concerne une installation de récupération d'énergie solaire destinée à être montée sur une charpente inclinée de toiture d'un bâtiment, ladite installation comprenant :
- une couverture pour couvrir la charpente, ayant des ondulations dans une direction longitudinale dans une direction de l'inclinaison de ladite charpente,
- des organes de fixation adaptés pour fixer ladite couverture à la charpente, lesdits organes de fixation comprenant une base ayant une forme complémentaire d'une ondulation de la couverture,
- des éléments élastiques entre les organes de fixation et la couverture,
- une structure de montage fixée sur lesdits organes de fixation, ladite structure de montage comprenant des profilés qui s'étendent selon la direction longitudinale, et
- des panneaux de récupération d'énergie solaire montés sur ladite structure de montage.

Une installation de ce type est connue du document AU 2009 245 849. On connaît également du document FR 2 920 453 une installation qui comprend en outre des profilés de montage dans une direction perpendiculaire à la direction longitudinale, directement supportés par la couverture, les panneaux de récupération d'énergie solaire étant montés sur lesdits profiles.

Une autre installation de récupération d'énergie solaire est divulguée dans le document FR2935410 A1.

La présente invention a pour but d'améliorer les installations connues. L'invention est définie à travers les caractéristiques de la revendiction 1.

A cet effet, dans une installation dans laquelle chaque organe de fixation comprend au moins un trou traversé par une vis pour fixer ledit organe de fixation sur la charpente, l'invention propose que chaque élément élastique comprenne une ouverture en correspondance dudit trou, ladite ouverture étant entourée d'un rebord faisant saillie.

Grâce à ces dispositions, l'étanchéité de l'installation et la tolérance aux dispersions dimensionnelles de la couverture sont améliorées.

De plus, l'installation peut être plus facilement installée sur la charpente du bâtiment.

En outre, l'installation n'ayant pas de profilés dans un sens perpendiculaire à la direction longitudinale, la ventilation et aération de l'installation est améliorée.

De plus, la charpente comprend souvent des pannes dans une direction perpendiculaire, lesdites pannes étant souvent fortement espacées, notamment de plus de 1,5 mètres. L'installation peut alors être montée sur une telle charpente avec une distance entre les profilés indépendante de la distance entre les pannes.

Dans divers modes de réalisation de l'installation selon l'invention, on peut éventuellement avoir recours en outre à l'une et/ou à l'autre des dispositions suivantes
- deux profilés successifs sont montés coulissants en translation l'un par rapport à l'autre dans la direction longitudinale, et
- les panneaux de récupération d'énergie solaire (5) sont montés sur ladite structure de montage, de telle sorte qu'aucun des panneaux de récupération d'énergie solaire n'est monté sur deux profilés successifs dans la direction longitudinale ;
- les profilés ont une longueur dans la direction longitudinale qui est multiple entier à 10 % près d'une dimension d'un des panneaux de récupération d'énergie solaire dans la même direction longitudinale ;
- les profilés ont une longueur dans la direction longitudinale, la longueur étant de préférence inférieure à 3 mètres ;
- les profilés comprennent des première et deuxième extrémités dans la direction longitudinale, la première extrémité étant destinée à être placée vers le bas et comprenant une butée adaptée pour retenir un premier panneau de récupération d'énergie solaire ;
- la butée est venue de matière avec le profilé ;
- une barre est engagée à l'intérieur des profilés successifs pour que le deuxième profilé soit coulissant par rapport au premier profilé, ladite barre étant solidarisée d'un des deux profilés successifs ;
- les organes de fixation comprennent en outre une paroi latérale s'étendant depuis la base en 's'éloignant vers le haut de la base, ladite paroi latérale étant adaptée pour fixer la structure de montage ;
- les organes de fixation comprennent aux moins deux moyens de fixation ;
- chaque élément élastique recouvre entièrement une surface inférieure d'un organe de fixation ;
- les panneaux de récupération d'énergie solaire sont des panneaux photovoltaïques.

D'autres caractéristiques et avantages de l'invention apparaîtront au cours de la description suivante d'un de ses modes de réalisation, donné à titre d'exemple non limitatif, en regard des dessins joints.

Sur les dessins :
- la figure 1 est une vue en perspective de l'installation de récupération d'énergie solaire selon l'invention,
- la figure 2 est une vue de face de la structure de montage et d'un organe de fixation de l'installation de la figure 1,
- la figure 3 est une vue en perspective d'une extrémité d'un profilé de la structure de montage de l'installation de la figure 1,
- la figure 4 est une vue en perspective d'une autre extrémité d'un profilé de la structure de montage de l'installation de la figure 1,
- la figure 5 est une vue en perspective de la connexion entre deux profilés successifs de la structure de montage de l'installation de la figure 1,
- la figure 6 est une vue de face d'un organe de fixation de l'installation de la figure 1.

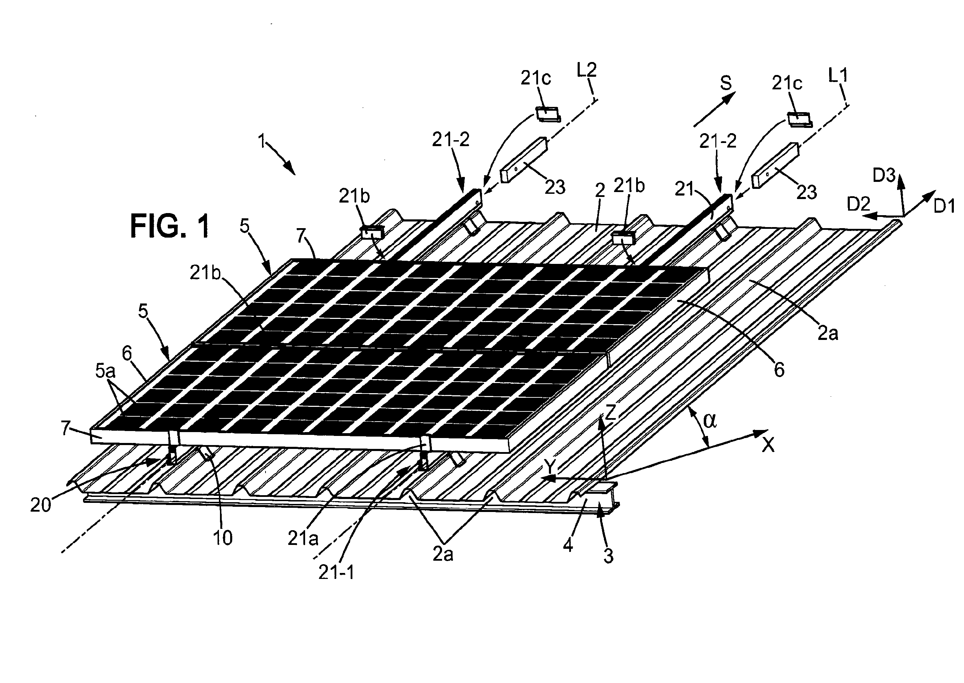

Sur les figures, les mêmes références désignent des éléments identiques ou analogues. Des directions X, Y, et Z sont indiquées sur la figure 1, la direction Z étant la direction verticale.

La figure 1 représente une vue générale d'un mode de réalisation de l'installation 1 de récupération d'énergie solaire selon l'invention. L'installation 1 est destinée à être montée sur un support adapté pour supporter l'installation de récupération d'énergie solaire. Par exemple, ce support peut être une charpente 3 de toiture d'un bâtiment.

La charpente 3 présente un sommet S dont la position est schématiquement indiqué par une flèche, depuis lequel s'étend vers le bas une pente selon une première direction D1, ladite pente ayant un angle généralement compris entre 4° et 60° par rapport à un plan horizontal (plan XY) perpendiculaire à la direction Z. Dans la suite, on désignera une direction par « vers le haut » une direction vers le sommet S dans la première direction D1, et « vers le bas » une direction opposée à cette dernière.

La charpente 3 peut comprendre des éléments support, dénommés chevrons, non-représentés, s'étendant parallèlement les uns aux autres selon la première direction D1 et des éléments support, dénommés liteaux ou pannes 4, s'étendant parallèlement les uns aux autres selon une deuxième direction D2 perpendiculaire à la première direction D1. La charpente représentée sur les figures est une charpente métallique, mais celle-ci peut être en bois.

La charpente 3 supporte une couverture 2. La couverture 2 s'étend sensiblement dans un plan correspondant à la première direction D1 et la deuxième direction D2. La couverture 2 a généralement des ondulations ou déformations longitudinales 2a s'étendant dans la première direction D1. La couverture peut être constituée de plaques de bacs aciers. Dans ce cas, les ondulations 2a ont souvent comme représenté un profil trapézoïdal dans une section perpendiculaire à la première direction D1. Ce profil est répétitif dans une deuxième direction D2. Cependant, tout type de profil est utilisable avec des ondulations sinus, en portion de cercles ou autre. De plus, tout type de plaques est utilisable : des plaques en acier, en aluminium, en fibrociment, en PVC, en matière plastique, en matière composite, ou autre.

La couverture 2 est orientée sur la charpente 3 du bâtiment de telle sorte que les ondulations soient dirigées dans la direction de la pente de la toiture, la première direction D1. La couverture 2 protège le bâtiment de la pluie et la pluie s'écoule facilement du sommet S de la charpente vers le bas en suivant des creux entre des sommets des ondulations de la couverture 2.

L'installation 1 de récupération d'énergie solaire comprend :
- la couverture 2 décrite ci-dessus,
- des organes de fixation 10 adaptés pour fixer la couverture 2 à la charpente 3 ou support,
- une structure de montage 20 fixée sur les organes de fixation 10, et
- plusieurs panneaux de récupération d'énergie solaire 5 montés sur ladite structure de montage 20.

La figure 1 montre deux panneaux de récupération d'énergie solaire agencés de manière adjacente selon la première direction D1. Les panneaux de récupération d'énergie solaire sont, par exemple, constitués par des panneaux photovoltaïques 5. Chaque panneau photovoltaïque 5 peut comprendre tel que représenté en figure 1 un réseau de cellules photovoltaïques 5a qui génèrent une énergie électrique à partir de la lumière du soleil, et un circuit électrique connecté au réseau pour transporter l'énergie électrique générée par les cellules photovoltaïques. Sur la figure 1, chacun des panneaux photovoltaïques 5 présente un contour rectangulaire avec deux bords longitudinaux 6 s'étendant selon la première direction D1 et deux bords transversaux 7 s'étendant selon la deuxième direction D2.

Les organes de fixation 10 comprennent :
- une base 11 ayant une forme complémentaire à une ondulation 2a de la couverture 2, et
- une paroi latérale 12 s'étendant depuis la base 11 vers le haut, dans une troisième direction D3 perpendiculaire aux deux autres.

Grâce à la forme complémentaire de la base 11 l'organe de fixation 10 peut être plaqué et positionné précisément sur une ondulation 2a de la couverture 2, et deux organes de fixation 10 montés sur une même ondulation de la couverture 2 sont naturellement correctement alignés l'un par rapport à l'autre, sans nécessiter obligatoirement des outils additionnels pour leur montage et pour leur alignement. Notamment, la base 11 peut avoir une forme en trapèze ou trapézoïdale qui épouse la forme de l'ondulation 2a d'un bac acier standard.

L'organe de fixation 10 comprend, sur sa base 11, un trou 13 positionné sur le sommet de la forme complémentaire de l'ondulation de la base 11, ce qui évite des infiltrations d'eau par ce trou à travers la couverture 2. Une vis 13a traverse ce trou 13 pour serrer et fixer l'organe de fixation 10 sur la couverture 2, et fixer la couverture 2 sur la charpente 3, la couverture 2 étant alors prise « en sandwich » entre ledit organe de fixation 10 et la charpente 3.

La base 11 de l'organe de fixation 10 a une forme complémentaire d'une ondulation 2a de la couverture 2, et comprend un sommet adapté pour venir sur le sommet d'une ondulation 2a et deux branches s'étendant vers le bas à l'opposé l'une de l'autre pour épouser la forme de l'ondulation 2a. Les branches se prolongent avantageusement jusque au creux ou « plage » de la couverture 2 de part et d'autre du sommet. De ce fait, lors du serrage de la vis 13a, la forme de l'ondulation de la couverture 2 n'est pas déformée sous l'organe de fixation 10, le positionnement de l'organe de fixation 10 sur la couverture 2 est alors correct, sans défaut d'alignement.

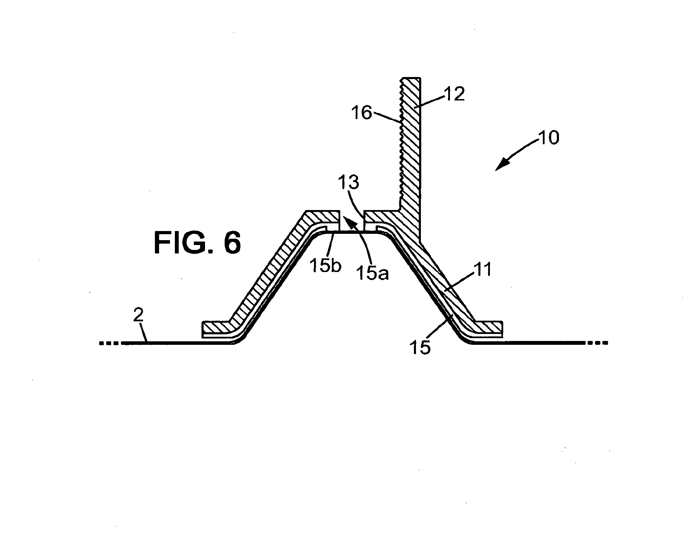

Comme montré en figure 6, un élément élastique 15 ayant une forme de plaque, éventuellement adaptée à la forme de l'ondulation est placée entre la base 11 de l'organe de fixation 10 et la couverture 2, pour réaliser une étanchéité, et éviter encore plus que de l'eau de pluie ne puisse s'infiltrer à travers la couverture 2 par l'intermédiaire du trou 13. Cet élément élastique 15 comprend une ouverture 15a à un emplacement en correspondance du trou 13 de la base 11.

L'élément élastique 15 peut recouvrir entièrement une surface inférieure de l'organe de fixation. Les organes de fixation 10 et la structure de montage 20, éléments généralement en matériau d'aluminium, sont alors isolés électriquement de la couverture 2, généralement en acier. On évite ainsi les phénomènes d'oxydation par électrolyse entre les matériaux métalliques.

L'élément élastique 15 a un rebord 15b annulaire autour de l'ouverture 15a, faisant saillie pour augmenter la compression de la matière de cet élément élastique 15 autour de son ouverture 15a, pour améliorer l'étanchéité et les tolérances aux dispersions dimensionnelles de la couverture 2. La figure 6 montre l'organe de fixation 10 et l'élément élastique 15 sur la couverture 2 en position avant serrage de la vis 13a pour mieux visualiser le rebord 15b. Avantageusement, l'élément élastique est constitué d'un matériau élastomère, tel que du caoutchouc, du caoutchouc naturel, un éthylène-propylène-diène monomère (EPDM).

L'organe de fixation 10 peut comprendre un deuxième trou 14 positionné avantageusement sur le sommet de la forme complémentaire et décalé dans la première direction D1 par rapport au premier trou 13. Une deuxième vis 14a traverse alors ce deuxième trou 14, pour améliorer le serrage et la fixation de la couverture 2 sur la charpente 3. Grâce à cette disposition, le montage est plus résistant et plus fiable. Notamment, le montage de la structure de montage 20 sur les organes de fixation 10 ne risque pas de provoquer des déplacements ou rotations des organes de fixation 10, l'étanchéité entre l'organe de fixation 10 et la couverture 2 ne peut être détériorée.

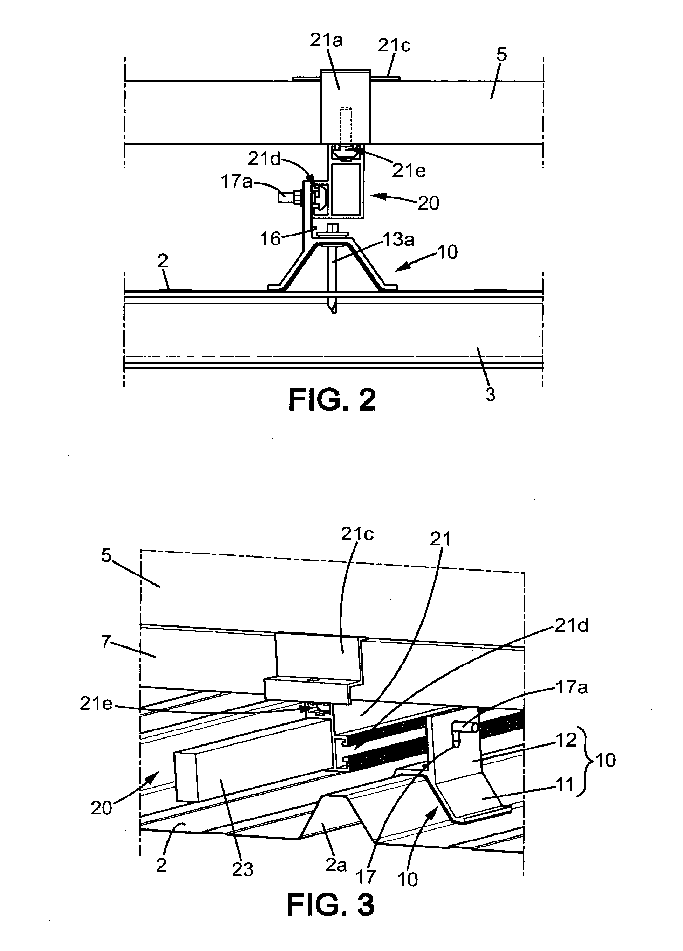

La paroi latérale 12 s'étend depuis la base 11 vers le haut, sensiblement dans la troisième direction D3 perpendiculaire aux première et deuxième directions D1, D2. Elle comprend une surface latérale 16 orientée du côté du sommet de la base 11, et un trou 17 adapté pour engager une vis 17a pour fixer la structure de montage 20 sur l'organe de fixation 10. Le trou 17 (figure 3) est avantageusement oblong dans une direction verticale (troisième direction D3), ce qui permet de compenser des différences de position dans la troisième direction D3 d'une couverture 2 qui ne serait pas placée dans un plans D1-D2 à cause de variations dans la charpente 3. Cette disposition permet également de compenser des variations dimensionnelles des ondulations 2a de la couverture. La structure de montage 20 et les panneaux de récupération de l'énergie du soleil 5 ne subissent plus ces variations et les contraintes mécaniques conséquentes.

La structure de montage 20 visible en figures 2 à 5 comprend des profilés 21, 22 montés sur les organes de fixation 10 et fixés par les vis 17a. Les profilés 21, 22 de la structure de montage 20 s'étendent selon la première direction D1 longitudinale, montés sur les organes de fixation 10. Ainsi, la structure de montage 20 est facilement et rapidement montée sur les organes de fixation 10, lesdits organes de fixation étant correctement positionnés et alignés sur la couverture 2. En outre, les profilés 21, 22 étant dans la première direction D1, l'aération sous l'installation 1 est améliorée puisque l'air peut facilement circuler sous et entre les profilés du bas de la charpente 3 vers le haut ou sommet S de la charpente 3.

Ces profilés 21, 22 sont organisés en lignes, parallèles l'une de l'autre dans la première direction D1, au moins deux lignes L1, L2 de profilés supportant un même panneau de récupération d'énergie solaire 5.

Chaque ligne L1, L2 peut comprendre un premier profilé 21 et un deuxième profilé 22, lesdits profilés étant montés coulissants en translation l'un par rapport à l'autre dans la première direction, par exemple par l'intermédiaire d'une barre 23 ou éclisse. La barre 23 est engagée à l'intérieur du premier profilé 21 et immobilisée par un moyen de blocage 23a, par exemple traversant au moins partiellement le premier profilé 21 et la barre 23. D'autre part, la barre 23 est engagée à l'intérieur du deuxième profilé 22 et sans immobilisation longitudinale.

Grâce à cette disposition, il existe un espace d'écartement 24 entre les premier et deuxième profilés 21, 22 permettant au premier profilé de se dilater ou de se contracter dans la première direction D1 longitudinale, sous l'effet des changements de température, sans exercer de contrainte sur le profilé successif, le deuxième profilé 22.

Chaque profilé 21, 22 a une longueur dans la première direction D1 inférieure à 5 mètres, et habituellement comprise entre 1 et 5 mètres. La dilatation ou la contraction des profilés dans la première direction D1 est ainsi limitée. Avantageusement, la longueur des profilés est inférieure à 3 mètres pour avoir des variations de longueur encore plus réduites lors de la dilatation ou la contraction thermique.

Chaque profilé 21, 22 comprend une première extrémité 21-1, 22-1 destinée à être placée vers le bas de la charpente 3 (à l'opposé du sommet S) et une deuxième extrémité 21-2, 22-2 à l'opposé de la première extrémité, c'est-à-dire vers le haut, vers le sommet S. Chaque profilé comprend à la première extrémité une butée 21 a, 22a pour retenir vers le bas les panneaux de récupération d'énergie solaire 5. Cette butée peut être visée sur le profilé. Avantageusement, la butée fait corps avec le profilé ou est venue de matière avec celui-ci : par exemple, elle peut être soudée sur le profilé, ou le profilé peut être déformé ou plié pour former la butée. Ainsi, la butée est indissociable du profilé, même lors de cycles de dilatation et contraction thermiques, et les panneaux de récupération d'énergie 5 ne risquent pas de se désolidariser de la structure de montage 20 par ces effets de dilatation thermique. Chaque butée comprend par exemple une saillie en partie supérieure. Un panneau de récupération d'énergie 5 est alors maintenu entre le profilé et ladite saillie dans la troisième direction D3.

Ainsi, un premier bord transversal 7 du premier panneau de récupération d'énergie solaire 5 est posé sur les premiers profilés de chaque ligne et en appui vers le bas sur lesdites butées 21 a. Des brides intermédiaires 21 b sont placées et vissées sur les premiers profilés 21 après le deuxième bord transversal 7 du premier panneau de récupération d'énergie 5 pour fixer ce premier panneau sur la structure de montage 20. Les brides intermédiaires 21 b ont une forme générale en U et comprennent également une saillie en partie supérieure pour maintenir le panneau 5 entre le profilé et ladite saillie dans la troisième direction D3.

Un premier bord transversal 7 du deuxième panneau de récupération d'énergie solaire 5 est posé sur les premiers profilés de chaque ligne et en appui vers le bas sur lesdites brides intermédiaires 21 b, et ainsi de suite.

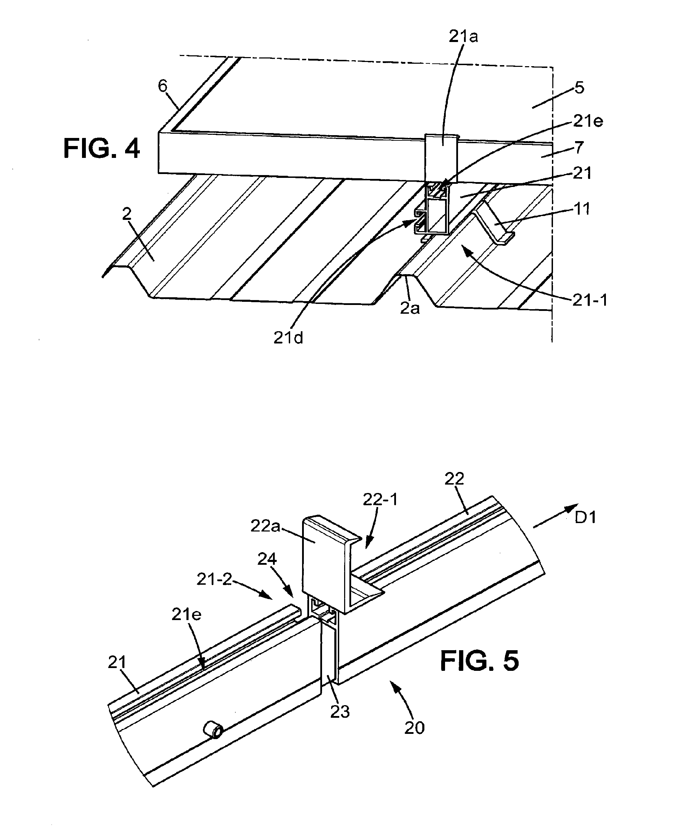

Une bride finale 21c, 22c (figure 4) équivalente à la butée 21a, 22a est placée et vissée après le deuxième bord 7 du dernier panneau de récupération d'énergie solaire 5 monté sur les premiers profilés 21.

Dans le mode de réalisation présenté, trois panneaux sont montés sur les premiers profilés 21 et sur les deuxièmes profilés 22, mais un nombre quelconque de panneaux peuvent être montés, la longueur dans la première direction D1 des premier et deuxième profilés 21, 22 étant alors adaptés, c'est-à-dire approximativement un multiple entier d'une dimension dans la première direction D1 d'un panneau de récupération d'énergie solaire 5. Les dimensions dans la première direction D1 des butées 21 a, 22a, des brides intermédiaires 21 b, 22b, et des brides finales 21 c, 22c s'ajoutent aux dimensions des panneaux 5 dans la première direction D1 pour atteindre la longueur d'un des profilés 21, 22. Cependant les dimensions de ces éléments additionnels sont faibles et représentent moins de 10 % de la longueur des profilés pour éviter de perdre de l'espace entre les panneaux 5 dont la surface ne contribue pas à la récupération d'énergie solaire. La longueur dans la première direction D1 des premier et deuxième profilés 21, 22 est donc un multiple entier d'une dimension dans la première direction D1 d'un panneau de récupération d'énergie solaire 5 à 10 % près.

Aucun des panneaux de récupération d'énergie solaire 5 n'est monté à cheval sur deux profilés 21, 22 successifs dans la direction longitudinale D1, au dessus de l'espace d'écartement 24 entre les premier et deuxième profilés 21, 22. Ainsi, la structure de montage 20 peut se dilater dans la première direction D1 d'une part sans générer des contrainte dans la couverture 2 puisque la couverture 2 a ses ondulations 2a dans la même direction D1 et d'autre part sans générer de contrainte mécanique dans les panneaux de récupération d'énergie solaire 5. Une telle installation 1 est ainsi non seulement plus facile à installer, mais également plus fiable et plus robuste dans la durée.

Le deuxième profilé 22 comprend des éléments identiques au premier profilé 21 : butée 22a, bride intermédiaire 22b, et bride finale 22c. Les panneaux de récupération d'énergie solaire 5, montés sur les deuxièmes profilés 22 (ligne L1 et L2), sont montés de la même manière sur ces deuxièmes profilés, que les panneaux de récupération d'énergie solaire 5 sont montés sur les premiers profilés 21. Ainsi, les panneaux de récupération d'énergie solaire 5 peuvent être pré-montés en usine sur les profilés 21, 22 pour former des modules pré-assemblés. Sur site, un premier module est alors monté sur les organes de fixation 10, avec des barres 23 pour prolonger les lignes L1, L2 dans la première direction D1. Un deuxième module est alors monté à la suite du premier module sur les organes de fixation 10 suivants, et ainsi de suite.

Ainsi, le montage de l'installation 1 est encore plus facilité, notamment sur site, sur la charpente 3 du bâtiment.

En outre, les profilés 21, 22 comprennent dans la première direction D1 des rainures 21 d, 21 e. La première rainure 21 d est adaptée pour accueillir la tête de la vis 17a pour fixer le profilé sur un organe de fixation 10. La deuxième rainure 21e est adaptée pour accueillir la tête de la vis des brides intermédiaires 21 b, 22b et des brides finales 21c, 22c.

Grâce à cette disposition, les profilés 21, 22 peuvent être fixés facilement latéralement, depuis l'extérieur de l'installation 1 sur les organes de fixation 10, et la position longitudinale dans la première direction D1 des profilés 21, 22 peut être aisément adaptée et des variations de position des organes de fixation 10 dans cette première direction importent peu pour le montage.

De même, les brides 21b, 22b, 21c, 22c peuvent facilement être fixées sur les profilés par le dessus depuis l'extérieur de l'installation 1 et la position longitudinale dans la première direction D1 de ces brides peut être aisément adaptée et des variations de position de ces brides dues à des panneaux de récupération d'énergie solaire ayant des longueurs différentes dans la direction D1 importent peu pour le montage de l'installation.

Ainsi, le montage est facilité et tolérant à des variations de positions ou de longueurs dans la première direction D1.

## Revendications

1. Installation (1) de récupération d'énergie solaire destinée à être montée sur une charpente (3) inclinée de toiture d'un bâtiment, ladite installation (1) comprenant :
- une couverture (2) pour couvrir la charpente (3), ayant des ondulations (2a) dans une direction longitudinale (D1) dans une direction de l'inclinaison de ladite charpente,
- des organes de fixation (10) adaptés pour fixer ladite couverture (2) à la charpente (3), lesdits organes de fixation (10) comprenant une base (11) ayant une forme complémentaire d'une ondulation (2a) de la couverture (2),
- des éléments élastiques (15) entre les organes de fixation (10) et la couverture (2),
- une structure de montage (20) fixée sur lesdits organes de fixation (10),
- des panneaux de récupération d'énergie solaire (5) montés sur ladite structure de montage (20),
- chaque organe de fixation (10) comprend au moins un trou (13) traversé par une vis (13a) pour fixer ledit organe de fixation sur la charpente (3) ladite installation (1) étant **caractérisée en ce que** ladite structure de montage (20) comprenant des profilés (21, 22) qui s'étendent selon la direction longitudinale (D1), et chaque elément élastique (15) comprend une ouverture (15a) en correspondance dudit trou (13), ladite ouverture (15a) étant entourée d'un rebord (15b) faisant saillie.

2. Installation selon la revendication 1, dans laquelle :
- deux profilés (21, 22) successifs sont montés coulissants en translation l'un par rapport à l'autre dans la direction longitudinale, et
- les panneaux de récupération d'énergie solaire (5) sont montés sur ladite structure de montage (20), de telle sorte qu'aucun des panneaux de récupération d'énergie solaire (5) n'est monté sur deux profilés (21, 22) successifs dans la direction longitudinale.

3. Installation selon la revendication 2, dans laquelle les profilés (21, 22) ont une longueur dans la direction longitudinale qui est multiple entier à 10 % près d'une dimension d'un des panneaux de récupération d'énergie solaire (5) dans la même direction longitudinale.

4. Installation selon l'une des revendications 2 et 3, dans laquelle les profilés (21, 22) ont une longueur dans la direction longitudinale, ladite longueur étant de préférence inférieure à 3 mètres.

5. Installation selon l'une des revendications 2 à 4, dans laquelle les profilés comprennent des première (21-1, 22-1) et deuxième (21-2, 22-2) extrémités dans la direction longitudinale (D1), la première extrémité (21-1, 22-1) étant destinée à être placée vers le bas et comprenant une butée (21 a, 22a) adaptée pour retenir un premier panneau de récupération d'énergie solaire (5).

6. Installation selon la revendication 5, dans laquelle la butée (21 a, 22a) est venue de matière avec le profilé (21, 22).

7. Installation selon l'une des revendications 2 à 6, dans laquelle une barre (23) est engagée à l'intérieur des profilés (21, 22) successifs pour que le deuxième profilé (22) soit coulissant par rapport au premier profilé (21), ladite barre (23) étant solidarisée d'un des deux profilés (21, 22) successifs.

8. Installation selon l'une quelconque des revendications 1 à 7, dans laquelle les organes de fixation (10) comprennent en outre une paroi latérale (12) s'étendant depuis la base (11) en s'éloignant vers le haut de la base, ladite paroi latérale (12) étant adaptée pour fixer la structure de montage (20).

9. Installation selon l'une des revendications précédentes, dans laquelle les organes de fixation (10) comprennent aux moins deux moyens de fixation (13a, 14a).

10. Installation selon l'une quelconque des revendications 1 à 9, dans laquelle chaque élément élastique (15) recouvre entièrement une surface inférieure d'un organe de fixation (10).

11. Installation selon l'une des revendications précédentes, dans laquelle les panneaux de récupération d'énergie solaire (5) sont des panneaux photovoltaïques.

## Patentansprüche

1. Anlage (1) zur Gewinnung von Sonnenenergie, dazu bestimmt, auf ein geneigtes Dach (3) eines Gebäudes montiert zu werden, wobei die genannte Anlage (1) umfasst:
- eine das Dach (3) bedeckende Überdeckung (2) mit Wellen (2a) mit einer Längsrichtung (D1) in einer Neigungsrichtung des genannten Daches,
- Befestigungsorgane (10), angepasst um die genannte Überdeckung (2) an dem Dach (3) zu befestigen, wobei die genannten Befestigungsorgane (10) eine Basis (11) mit einer zu einer Welligkeit (2a) der Überdeckung (2) komplementären Form umfassen,
- elastische Elemente (15) zwischen den Befestigungsorganen (10) und der Überdeckung (2),
- eine an den genannten Befestigungsorganen (10) befestigte Montagestruktur (20),
- auf die genannte Montagestruktur (20) montierte Paneele bzw. Module zur Solarenergie-Rückgewinnung (5),
wobei jedes Befestigungsorgan (10) wenigstens ein Loch (13) umfasst, durchquert von einer Schraube (13a), um das genannte Befestigungsorgan (10) an der Überdeckung (3) zu befestigen, wobei die genannte Anlage (1) **dadurch gekennzeichnet ist, dass** die genannte Montagestruktur (20) Profile (21, 22) umfasst, die sich gemäß der Längsrichtung (D1) erstrecken, und jedes elastische Element (15) eine mit dem genannten Loch (13) übereinstimmende Öffnung (15a) umfasst und die genannte Öffnung (15a) umgeben ist von einem vorstehenden Rand (15b).

2. Anlage nach Anspruch 1, bei der:
- zwei aufeinanderfolgende Profile (21, 22) gegenseitig in einer Längsrichtung parallelverschiebbar montiert sind, und
- die genannten Solarenergie-Rückgewinnungsmodule (5) derartig auf die genannte Montagestruktur (20) montiert sind, dass keines der Solarenergie-Rückgewinnungsmodule (5) auf zwei in der Längsrichtung aufeinanderfolgende Profile (21, 22) montiert ist.

3. Anlage nach Anspruch 2, bei der die Profile (21, 22) in der Längsrichtung eine Länge haben, die bis auf 10 % ein ganzes Vielfaches einer Dimension eines der genannten Solarenergie-Rückgewinnungsmodule (5) in der gleichen Längsrichtung ist.

4. Anlage nach einem der Ansprüche 2 und 3, bei der die Profile (21, 22) eine Länge in der Längsrichtung haben, wobei die genannte Länge vorzugsweise kleiner als 3 Meter ist.

5. Anlage nach einem der Ansprüche 2 bis 4, bei der die Profile erste (21-1, 22-1) und zweite (21-2, 22-2) Enden in der Längsrichtung (D1) umfassen, wobei das erste Ende (21-1, 22-1) dazu bestimmt ist, nach unten angeordnet zu sein, dabei einen Anschlag (21a, 22a) umfassend, angepasst um ein erstes Solarenergie-Rückgewinnungsmodul (5) festzuhalten.

6. Anlage nach Anspruch 5, bei der der Anschlag (21 a, 22a) aus einem Stück ist mit dem Profil (21, 22).

7. Anlage nach einem der Ansprüche 2 bis 6, bei der eine Stange (23) sich im Innern der aufeinanderfolgenden Profile (21, 22) befindet, so dass das zweite Profil (22) in Bezug auf das erste Profil (21) verschiebbar ist, wobei die genannte Stange (23) fest verbunden ist mit einem der beiden aufeinanderfolgenden Profile (21, 22).

8. Anlage nach einem der Ansprüche 1 bis 7, bei der die Befestigungsorgane (10) außerdem eine Seitenwand (12) umfassen, die sich nach oben erstreckend von der Basis (11) entfernt, wobei die genannte Seitenwand (12) angepasst ist, um die Montagestruktur (20) zu fixieren bzw. zu befestigen.

9. Anlage nach einem der vorhergehenden Ansprüche, bei der die Befestigungsorgane (10) mindestens zwei Befestigungseinrichtungen (13a, 14a) umfassen.

10. Anlage nach einem der vorhergehenden Ansprüche 1 bis 9, bei der jedes elastische Element (15) eine untere Oberfläche eines Befestigungselements (10) vollständig bedeckt.

11. Anlage nach einem der vorhergehenden Ansprüche, bei der die Solarenergie-Rückgewinnungsmodule (5) photovoltaische Paneele sind.

## Claims

1. An installation (1) for collecting solar energy, intended to be mounted on an inclined roof framework (3) of a building, said installation (1) comprising:
- a cover (2) for covering the framework (3), having corrugations (2a) in a longitudinal direction (D1) in an inclination direction of the framework;
- fixing members (10) suitable for fixing said cover (2) to the framework (3), said fixing members (10) comprising a base (11) having a shape complementary to a corrugation (2a) of the cover (2);
- elastic elements (15) between the fixing members (10) and the cover (2);
- an assembly structure (20) attached to said fixing members (10),
- panels (5) for collecting solar energy mounted on said assembly structure (20).
each fixing member (10) comprises at least one hole (13) penetrated by a screw (13a) for fixing said fixing member to the framework (3), said installation (1) is **characterized in that** said assembly structure (20) comprising profiled elements (21, 22) extending in the longitudinal direction (D1); and each elastic element (15) comprises an opening (15a) opposite said hole (13), said opening (15a) being surrounded by a protruding edge (15b).

2. The installation according to claim 1, wherein:
- two successive profiled elements (21, 22) are slidably mounted in translation with respect to one another in the longitudinal direction, and
- solar collection panels (5) are mounted on said assembly structure (20), in such a manner that non of the solar collection panels (5) is mounted on two successive profiled elements (21, 22) in the longitudinal direction.

3. The installation according to claim 2, wherein the profiled elements (21, 22) have a length in the longitudinal direction which is an integer multiple, to within 10%, of a dimension of one of the solar collection panels (5) in the same longitudinal direction.

4. The installation according to one of claims 2 and 3, wherein the profiled elements (21, 22) have a length in the longitudinal direction, said length being preferably less than 3 meters.

5. The installation according to one of claims 2 to 4, wherein the profiled elements comprise a first (21-1, 22-1) and a second (21-2, 22-2) ends in the longitudinal direction (D1), the first end (21-1, 22-1) being intended to be placed down and comprising a stop (21a, 22a) adapted to retain a first solar collection panel (5).

6. The installation according to claim 5, wherein the stop (21a, 22a) is integral with the profiled element (21, 22).

7. The installation according to one of claims 2 to 6, wherein a bar (23) is engaged inside the successive profiled elements (21, 22) in a manner that the second profiled element (22) is slidable relative to the first profiled element (21), said bar (23) being secured to one of the two successive profiled elements (21, 22).

8. The installation according to any one of claims 1 to 7, wherein the fixing members (10) further comprise a side wall (12) extending from the base (11) moving away upwards the base, said sidewall (12) being adapted to secure the assembly structure (20).

9. The installation according to any one of the preceding claims, wherein the fixing members (10) comprise at least two fixing means (13a, 14a).

10. The installation according to any one of claims 1 to 9, wherein each elastic element (15) completely covers a lower surface of a fixing member (10).

11. The installation according to any one of the preceding claims, wherein the solar collection panels (5) are photovoltaic panels.
